# EUROPEAN PATENT SPECIFICATION

(11) **EP 2 927 965 B1**
(45) Date of publication and mention of the grant of the patent: **12.07.2017**
(21) Application number: 15164604.9
(22) Date of filing: 14.05.2009
(51) Int. Cl.: H01L 29/786, H01L 29/66, H01L 27/12

(54) **SEMICONDUCTOR DEVICES**
HALBLEITERBAUELEMENTE
DISPOSITIFS SEMI-CONDUCTEURS

(30) Priority: 15.05.2008 KR 20080045108; 30.09.2008 KR 20080096027
(43) Date of publication of application: 07.10.2015
(62) Divisional of application: 11183826.4
(73) Proprietor: Samsung Electronics Co., Ltd, Gyeonggi-do 443-742 (KR)
(72) Inventor: Park, Jae-chul, Gyeonggi-do 443-803 (KR); Kwon, Kee-won, Gyeonggi-do 443-803 (KR)
(74) Representative: Portch, Daniel

(56) References cited:
- US-A1- 2005 017 302
- US-A1- 2005 275 038

## Description

### BACKGROUND

### 1. Field

One or more embodiments relate to a semiconductor device, and more particularly, to a semiconductor device including a thin film transistor (TFT) and a method of manufacturing the semiconductor device.

### 2. Description of the Related Art

Thin film transistors (TFTs) are used as switching devices and driving devices in flat display devices such as liquid crystal display devices (LCDs) or organic light emitting display devices (OLEDs). The performance of a TFT is greatly affected by the material and state of a channel layer through which charge carriers travel.

Generally, a conventional flat display device includes an amorphous silicon TFT having a channel layer formed of amorphous silicon, or a polycrystal silicon TFT having a channel layer formed of polysilicon.

The charge mobility of an amorphous silicon TFT is about 0.5 cm²/Vs, which is very low, and thus it is difficult to increase the operating speed of such flat display device. Generally, an amorphous silicon TFT has a bottom gate structure. Due to such structure, some problems can occur. In particular, in the bottom gate structure, portions of a source and a drain overlap a portion of a gate, and thus a parasitic capacitance is increased, thereby reducing the operating speed of the TFT. In addition, since to the overlapped portions need to be ensured, it is difficult to achieve scale-down of devices.

In order to manufacture a polycrystal silicon TFT, since crystallization, impurities injection, and activation are required, the manufacturing process is more complicated and the manufacturing cost is increased compared to the case of an amorphous silicon TFT. In addition, since the size of crystalline particle of a polycrystal silicon layer is irregular, when a polycrystal silicon layer is used as a channel layer in a large size display device, image quality deteriorates. Thus, a polycrystal silicon TFT is restrictively used in a small-sized display device.

US 2008/038882 discloses a thin-film device comprising an oxide semiconductor film which comprises bulk layer, a first interface layer and a second interface layer, wherein the bulk layer has a higher density of oxygen holes than the interface layers.

US 2005/017302 discloses thin-film device having a channel region that includes a doped portion.

### SUMMARY

According to a first aspect of the invention, there is provided a thin film transistor (TFT) according to claim 1.

Embodiments will be set forth in part in the description which follows and, in part, will be apparent from the description, or may be learned by practice of the invention.

The first source region and the first drain region may be plasma-treated.

Each of the first source region and the first drain region may include two regions having different conductivities, wherein a region of the two regions, having smaller conductivity than the other region, is adjacent to the first channel region.

Each of the first source region and the first drain region may include two regions having different conductivities, wherein a region of the two regions, having smaller conductivity than the other region, is adjacent to the first channel region.

The semiconductor device may further include first insulating spacers on both side walls of the first stack structure, wherein the region of the two regions, having smaller than conductivity than the other region, is disposed below each of the first insulating spacers.

The semiconductor may further include a second TFT, wherein the second TFT may include a second oxide semiconductor layer having a second source region, a second drain region, and a second channel region between the second source region and the second drain region; and a second stack structure including a second gate insulating layer and a second gate electrode, which are sequentially stacked on the second channel region.

The second oxide semiconductor layer may has a type that is the same as or different from the first oxide semiconductor layer.

When the second oxide semiconductor layer comprises a different type from the first oxide semiconductor layer, an insulating layer may be disposed between the substrate and the second TFT, and the first and second oxide semiconductor layers may be disposed on different layers.

The semiconductor device may further include a bottom gate electrode disposed below at least one of the first channel region and the second channel region.

The second source region and the second drain region may be plasma-treated.

Each of the second source region and the second drain region may include two regions having different conductivities, wherein a region of the two regions, having smaller conductivity than the other region, is adjacent to the second channel region.

The semiconductor device may further include second insulating spacers on both side walls of the second stack structure, wherein the region of the two regions, having smaller than conductivity than the other region, is disposed below each of the second insulating spacers.

### BRIEF DESCRIPTION OF THE DRAWINGS

These and/or other aspects will become apparent and more readily appreciated from the following description of the embodiments, taken in conjunction with the accompanying drawings of which:
FIG. 1 shows a thin film transistor (TFT),
FIG. 2 is a cross-sectional view of a semiconductor device including a TFT of FIG.1,
FIGS. 3A through 3F are cross-sectional views for explaining a method of manufacturing a TFT,
FIGS. 4A and 4B are cross-sectional views for explaining steps of a method of manufacturing a TFT,
FIG. 5 is a graph illustrating a sheet resistance with respect to a period of time during which plasma-treating is performed with respect to an active layer included in a TFT;
FIG. 6 is a graph illustrating gate voltage - drain current characteristics versus a drain voltage of the TFT of FIG. 3F;
FIGS. 7A through 7H are cross-sectional views for explaining a method of manufacturing a semiconductor device including the TFT of FIG. 3F,
FIG. 8 is a cross-sectional view of a TFT,
FIGS. 9 and 10 are cross-sectional views of a semiconductor device including TFTs,
FIG. 11 is a cross-sectional view of a TFT, according to an embodiment; and
FIGS. 12 and 13 are cross-sectional views of a semiconductor device including TFTs, according to embodiments.

### DETAILED DESCRIPTION

Various example embodiments will now be described more fully with reference to the accompanying drawings in which some example embodiments are shown.

Detailed illustrative example embodiments are disclosed herein. However, specific structural and functional details disclosed herein are merely representative for purposes of describing example embodiments. This invention may, however, may be embodied in many alternate forms and should not be construed as limited to only the example embodiments set forth herein.

Accordingly, while example embodiments are capable of various modifications and alternative forms, embodiments thereof are shown by way of example in the drawings and will herein be described in detail. It should be understood, however, that there is no intent to limit example embodiments to the particular forms disclosed, but on the contrary, example embodiments are to cover all modifications, equivalents, and alternatives falling within the scope of the invention. Like numbers refer to like elements throughout the description of the figures.

It will be understood that, although the terms first, second, etc. may be used herein to describe various elements, these elements should not be limited by these terms. These terms are only used to distinguish one element from another. For example, a first element could be termed a second element, and, similarly, a second element could be termed a first element, without departing from the scope of example embodiments. As used herein, the term "and/or," includes any and all combinations of one or more of the associated listed items.

It will be understood that when an element or layer is referred to as being "formed on," another element or layer, it can be directly or indirectly formed on the other element or layer. That is, for example, intervening elements or layers may be present. In contrast, when an element or layer is referred to as being "directly formed on," to another element, there are no intervening elements or layers present. Other words used to describe the relationship between elements or layers should be interpreted in a like fashion (e.g., "between," versus "directly between," "adjacent," versus "directly adjacent," etc.).

The terminology used herein is for the purpose of describing particular embodiments only and is not intended to be limiting of example embodiments. As used herein, the singular forms "a," "an," and "the," are intended to include the plural forms as well, unless the context clearly indicates otherwise. It will be further understood that the terms "comprises," "comprising," "includes," and/or "including," when used herein, specify the presence of stated features, integers, steps, operations, elements, and/or components, but do not preclude the presence or addition of one or more other features, integers, steps, operations, elements, components, and/or groups thereof.

In the drawings, the thicknesses of layers and regions are exaggerated for clarity. Like reference numerals in the drawings denote like elements.

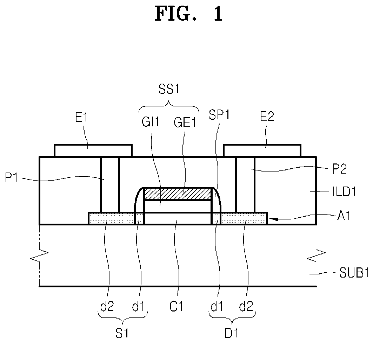

FIG. 1 shows a thin film transistor (TFT).

Referring to FIG. 1, a first active layer A1 is disposed on a substrate SUB1. The first active layer A1 may be formed of a first oxide semiconductor of a first type. When the first type is an n-type, the first active layer A1 may be, for example, a ZnO-based oxide layer. In this case, the first active layer A1 may further include a group 3 element such as In or Ga, a 4 element such as Sn, or other elements. When the first type is a p-type, the first active layer A1 may be, for example, a Cu oxide layer (CuBO₂ layer, CuAlO₂ layer, CuGaO₂ layer, CuInO₂ layer, etc.), an Ni oxide layer, an Ni oxide layer doped with Ti, a ZnO-based oxide layer doped with at least one of group 1, 2 and 5 elements, a ZnO-based oxide layer doped with Ag, a PbS layer, a LaCuOS layer or a LaCuOSe layer.

A first stack structure SS1 including a first gate insulating layer GI1 and a first gate electrode GE1, which are sequentially stacked, is disposed on a channel region (hereinafter, referred to as a first channel region C1) of the first active layer A1. First insulating spacers SP1 may be disposed on both side walls of the first stack structure SS1. A first source region S1 and a first drain region D1 are respectively disposed in portions of the first active layer A1, which are disposed on both side walls of the first stack structure SS1. As shown in FIG. 1, the first source region S1 and the first drain region D1 do not overlap the first gate electrode GE1. Also, the first source region S1 and the first drain region D1 are coplanar with and do not overlap the first channel region C1.

Each of the first source region S1 and the first drain region D1 may include two regions (hereinafter, referred to as first and second conductive regions d1 and d2) having different conductivities. The first conductive region d1 may be disposed adjacent to the first channel region C1. That is, the first conductive region may be below the first insulating spacer SP1. The conductivity of the first conductive region d1 may be smaller than the conductivity of the second conductive region d2. The first conductive region d1 may be similar to a lightly doped drain (LDD) region. The first source region S1 and the first drain region D1 may each be plasma-treated. For example, when the portions of the first active layers A1, which are disposed on the both side walls of the first stack structure SS1, are plasma-treated with single gas plasma (e.g., argon (Ar) plasma, xenon (Xe) plasma, hydrogen (H) plasma or hydrogen (H) containing gas plasma) or mixture gas plasma (e.g., plasma of mixture gas containing SF₆ and O₂), the portions of the first active layers A1 obtain conductivity so as to be the first source region S1 and the first drain region D1, respectively. A period of time or the number of time for plasma-treating of the first conductive region d1 may be smaller than that of the second conductive region d2. However, the first source region S1 and the first drain region D1 may be regions doped with conductive impurities, instead of plasma-treated regions. In this case, the first conductive region d1 may be a low concentration doping region, and the second conductive region d2 may be a high concentration doping region. The first insulating spacer SP1 and the first conductive region d1 may be optionally provided.

A first interlayer insulating layer ILD1 covering the first stack structure SS1, the first insulating spacer SP1, the first source region S1 and the first drain region D1 may be disposed on the substrate SUB1. First and second electrodes E1 and E2 that are electrically connected to the first source region S1 and the first drain region D1 may be disposed on the first interlayer insulating layer ILD1. The first source region S1 and the first electrode E1 may be connected to each other by a first conductive plug P1. The first drain region D1 and the second electrode E2 may be connected to each other by a second conductive plug P2. A passivation layer (not shown) covering the first and second electrodes E1 and E2 may further be disposed on the first interlayer insulating layer ILD1.

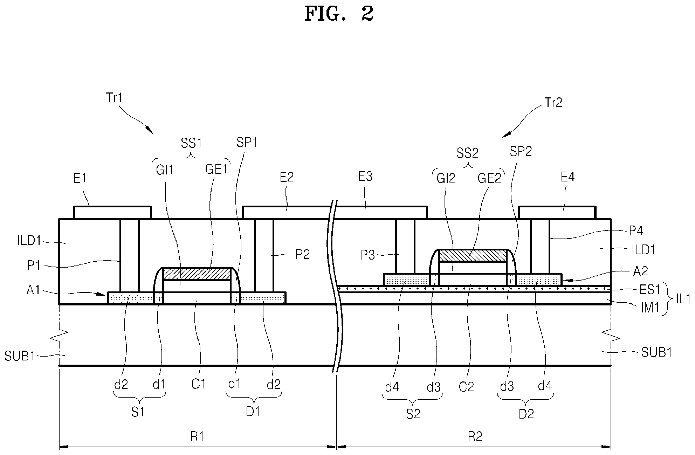

FIG. 2 is a cross-sectional view of a semiconductor device including a TFT. The semiconductor device includes a TFT (hereafter, referred to as a first type TFT Tr1) of FIG. 1 and a different type TFT (hereinafter, referred to as a second type TFT Tr2). That is, the semiconductor device may be a complementary semiconductor device similar to a complementary metal oxide semiconductor (CMOS).

Referring to FIG. 2, the first type TFT Tr1 is disposed on a first region R1 of the substrate SUB1. The second type TFT Tr2 is disposed on a second region R2 of the substrate SUB1. The first type TFT Tr1 may be the same as the TFT of FIG. 1, and thus its description will not be repeated. The second type TFT Tr2 may be disposed on an insulating layer IL1 disposed on the substrate SUB1. The insulating layer IL1 may be a single layer or a multilayer. For example, the insulating layer IL1 may include a first layer IM1 and a second layer ES1 disposed on the first layer IM1. In this case, the first layer IM1 may be formed of the same material as the first gate insulating layer GI1. The second layer ES1 may be formed of a different material from the first layer IM1. Etch selectivity between the first and second layers IM1 and ES1 may be large. If necessary, the second layer ES1 may not be provided. The structure of the second type TFT Tr2 may be similar to that of the first type TFT Tr1. In more detail, the second type TFT Tr2 may include a second active layer A2 disposed on the insulating layer IL1, a second stack structure SS2 including a second gate insulating layer GI2 and a second gate electrode GE2, which are sequentially stacked on a channel region (hereinafter, referred to as a second channel region C2) of the second active layer A2, and a second source region S2 and a second drain region D2, which are disposed in portions of the second active layer A2, which are disposed on both sides of the second stack structure SS2. Second insulating spacers SP2 may be disposed on both side walls of the second stack structure SS2. The second active layer A2 may be an oxide semiconductor layer of an opposite type to the first active layer A1. When the second active layer A2 is an p-type, the second active layer A2 may be, for example, a Cu oxide layer, an Ni oxide layer, an Ni oxide layer doped with Ti, a ZnO-based oxide layer doped with at least one of group 1, 2 and 5 elements, or a ZnO-based oxide layer doped with Ag. When the second active layer A2 is an n-type, the second active layer A2 may be, for example, a ZnO-based oxide layer. In this case, the second active layer A2 may further include a group 3 element such as In or Ga, a group 4 element such as Sn, or other elements. Each of the second source region S2 and the second drain region D2 may include two regions (hereinafter, referred to as third and fourth conductive regions d3 and d4) having different conductivities. The third conductive region d3 may be disposed adjacent to the second channel region C2. The third conductive region d3 may be disposed below the second insulating spacer SP2. The conductivity of the third conductive region d3 may be smaller than that of the fourth conductive region d4. That is, the third conductive region d3 may be similar to an LDD region. The second source region S2 and the second drain region D2 may each be a plasma-treated region or a region doped with conductive impurities, like in the case of the first source region S1 and the first drain region D1. The second insulating spacer SP2 and the third conductive region d3 may be optionally provided. A first interlayer insulating layer ILD1 covering the second stack structure SS2, the second insulating spacer SP2, the second source region S2 and the second drain region D2 may be disposed on the insulating layer IL1. Third and fourth electrodes E3 and E4, which are electrically connected to the second source region S2 and the second drain region D2, may be disposed on the first interlayer insulating layer ILD1. The second source region S2 and the third electrode E3 may be connected to each other by a third conductive plug P3. The second drain region D2 and the fourth electrode E4 may be connected to each other by a fourth conductive plug P4. A passivation layer (not shown) covering the third and fourth electrodes E3 and E4 may further be disposed on the first interlayer insulating layer ILD1. A TFT includes an oxide semiconductor layer as a channel layer. The oxide semiconductor layer may have uniform electric characteristics across its entire area unlike a polycrystal silicon layer. Thus, a large size display apparatus including the TFT can be realized. In addition, when the oxide semiconductor layer is used as a channel layer, a de-hydrogen process and a crystallization process are not required for forming the channel layer. Since a source region and a drain region can be formed by only plasma-treating, instead of an impurity-doping process and an activation process, a manufacturing process can be simplified and manufacturing costs can be reduced. In addition, the TFT has a self-align top gate structure. In this regard, the source region and the drain region may not overlap a gate electrode. As a result, this structure is advantageous in scale-down of a device and improvement of operating speed. Since the oxide semiconductor layer used as the channel layer has greater charge mobility than an amorphous silicon layer or a polycrystal silicon layer, when the TFT is used, a display apparatus having great operating speed can be realized.

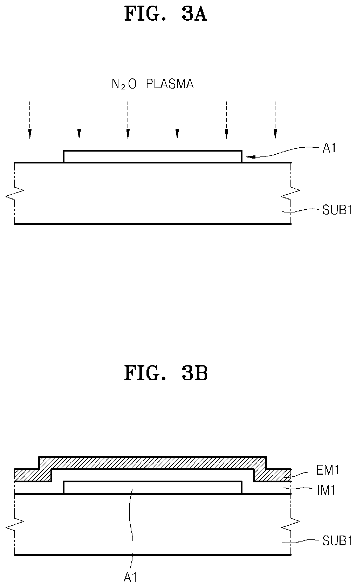

FIGS. 3A through 3F are cross-sectional views for explaining a method of manufacturing a TFT. Referring to FIG. 3A, a first active layer A1 is formed on a substrate SUB1. The first active layer A1 may be formed of a first oxide semiconductor of a first type. When the first type is an n-type, the first active layer A1 may be, for example, a ZnO-based oxide layer. In this case, the first active layer A1 may further include a group 3 element such as In or Ga, a group 4 element such as Sn, or other elements. When the first type is a p-type, the first active layer A1 may be, for example, a Cu oxide layer (CuBO₂ layer, CuAlO₂ layer, CuGaO₂ layer, CuInO₂ layer, etc.), an Ni oxide layer, an Ni oxide layer doped with Ti, a ZnO-based oxide layer doped with at least one of group 1, 2 and 5 elements, a ZnO-based oxide layer doped with Ag, a PbS layer, a LaCuOS layer or a LaCuOSe layer.

Next, the first active layer A1 may be plasma-treated. The plasma may be oxygen containing gas plasma, for example, N₂O plasma. When the first active layer A1 is plasma-treated, oxygen permeates a surface portion of the first active layer A1, thereby reducing the conductivity of the surface portion of the first active layer A1. Then, when a first insulating material layer IM1 (see FIG. 3B) may be deposited on the first active layer A1, hydrogen permeates a surface portion of the first active layer A1, thereby increasing the conductivity of the surface portion of the first active layer A1 back to level of semiconductor conductivity. If the above plasma-treating is not performed prior to forming the first insulating material layer IM1, since the conductivity of the surface portion of the first active layer A1 is increased too much, the semiconductor properties of the first active layer A1 become the same as metallic properties. In order to overcome this problem, the plasma-treating may be performed prior to the forming of the first insulating material layer IM1. However, because of the material of the first active layer A1 and a gas used for forming the first insulating material layer IM1, the plasma-treating with respect to the first active layer A1 may not be performed.

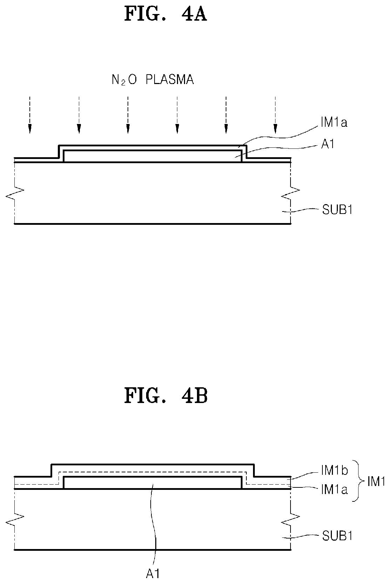

The plasma-treating with respect to the first active layer A1, illustrated in FIG. 3A, may be variously changed. For example, as illustrated in FIGS. 4A and 4B, the first insulating material layer IM1 may be formed using at least two operations, and the first active layer A1 may be plasma-treated between the at least two operations. In more detail, as illustrated in FIG. 4A, when a portion (hereinafter, referred to as a lower layer IM1a) of the first insulating material layer IM1 is formed, the first active layer A1 is plasma-treated. Then, as illustrated in FIG. 4B, the other portion (hereinafter, referred to as an upper layer IM1 b) of the first insulating material layer IM1 is formed. In this case, the thickness of the lower layer IM1a may be smaller than the thickness of the upper layer IM1b. This is because if the lower layer IM1a is excessively thick, it is difficult to perform a plasma-treatment with respect to the first active layer A1. In addition, the hydrogen concentration of hydrogen in a deposition gas used for forming the lower layer IM1a may be smaller than in the case of the upper layer IM1b in order to reduce the amount of hydrogen permeating the first active layer A1 when forming the lower layer IM1a. Although not illustrated, as a modified example, after forming the first insulating material layer IM1, the first active layer A1 may be plasma-treated. In this case, the intensity of the plasma may be very large, and the thickness of the first insulating material layer IM1 may be small.

Referring to FIG. 3B, a first insulating material layer IM1 covering the first active layer A1 is formed on the substrate SUB1. The first insulating material layer IM1 may be, for example, a silicon oxide layer. In this case, the first insulating material layer IM1 may be formed by plasma enhanced chemical vapor deposition (PECVD) using SiH₄ containing gas. Then, a first electrode material layer EM1 is formed on the first insulating material layer IM1.

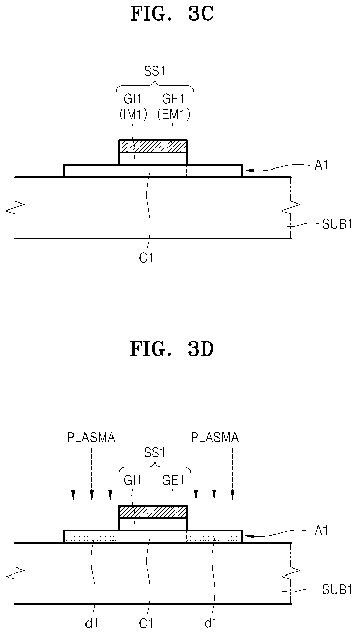

Then, the first electrode material layer EM1 and the first insulating material layer IM1 are sequentially etched so that the first stack structure SS1 is left on a channel region (referred to as a first channel region C1) of the first active layer A1, as illustrated in FIG. 3C. When the first electrode material layer EM1 and the first insulating material layer IM1 are etched, a mixture gas of SF₆ and O₂ may be used as an etching gas. In FIG. 3C, a reference numeral GI1 denotes an etched first insulating material layer (hereinafter, referred to as a first gate insulating layer GI1), and a reference numeral GE1 denotes an etched first electrode material layer (hereinafter, referred to as a first gate electrode GE1).

Referring to FIG. 3D, first plasma-treating is performed with respect to portions of the first active layer A1, which are disposed on both sides of the first stack structure SS1 so that first conductive regions d1 are formed in the portions of the first active layers A1, which are disposed on the both sides of the first stack structure SS1. The first conductive regions d1 may have conductivity similar to that of a general LDD region. The above first plasma-treating is performed with the etching gas (e.g., a mixture gas of SF₆ and O₂) plasma used for etching the first electrode material layer EM1 and the first insulating material layer IM1, illustrated in FIG. 3B. Alternatively, other plasma, for example, argon (Ar) plasma, xenon (Xe) plasma, hydrogen (H) plasma or hydrogen (H) containing gas plasma may be used. By the first plasma-treating, the composition of the surface portion of the first active layer A1 is changed, thereby increasing the conductivity of the surface portion of the first active layer A1. In more detail, if the first active layer A1 is a GalnZnO layer, the In concentration of a surface portion of the GalnZnO layer may be increased by the first plasma-treating, thereby increasing the conductivity of the surface portion of the GalnZnO layer. For example, the sheet resistance of the first conductive region d1 to which the first plasma-treating is performed may be about 50 kΩ/sq.

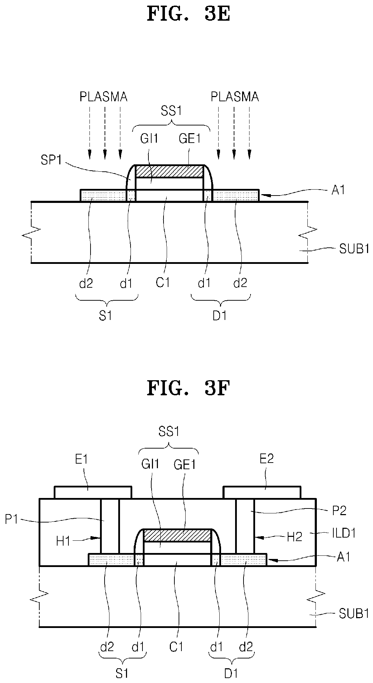

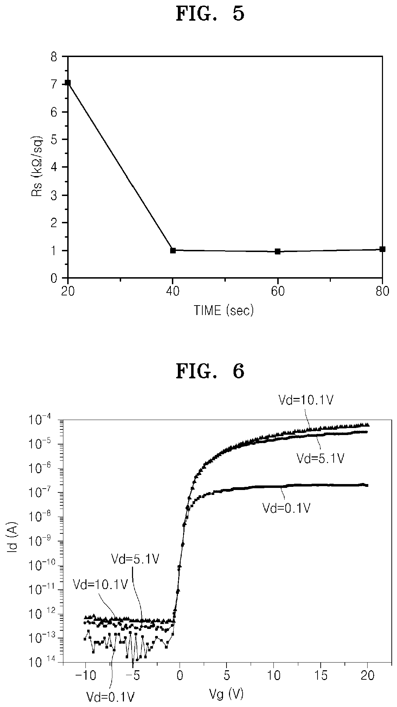

Referring to FIG. 3E, first insulating spacers SP1 are formed on both side walls of the first stack structure SS1. Then, second plasma-treating is performed to the first conductive regions d1 disposed on both sides of the first stack structure SS1 and the first insulating spacer SP1 so as to form second conductive regions d2. The first and second conductive regions d1 and d2 of one side of the first stack structure SS1 may be a first source region S1, and the first and second conductive regions d1 and d2 of the other side of the first stack structure SS1 may be a first drain region D1. Since a second plasma-treated region, that is, the second conductive region d2, has high conductivity, the second conductive region d2 may be similar to a region highly doped with conductive impurities. By the second plasma-treating, the composition of the surface portion of the first active layer A1 may also be changed, thereby further increasing the conductivity of the surface portion of the first active layer A1. For example, the sheet resistance of the second conductive region d2 to which the second plasma-treating is performed may be about 1 kΩ/sq. The variation in the sheet resistance Rs of the second conductive region d2, which is changed according to a period of time during which the second plasma-treating is performed, can be seen with reference to FIG. 5. When performing the second plasma-treating, argon (Ar) plasma, xenon (Xe) plasma, hydrogen (H) plasma, hydrogen (H) containing gas plasma or other plasma may be used.

Referring to FIG. 3F, a first interlayer insulating layer ILD1 covering the first stack structure SS1, the first insulating spacer SP1, the first source region S1 and the first drain region D1 may be formed on the substrate SUB1. By etching the first interlayer insulating layer ILD1, first and second contact holes H1 and H2, which respectively expose the first source region S1 and the first drain region D1, are formed. The first conductive plug P1 and the second conductive plug P2 may be formed in the first and second contact holes H1 and H2, respectively. Then, the first electrode E1 in contact with the first conductive plug P1 and the second electrode E2 in contact with the second conductive plug P2 may be formed on the first interlayer insulating layer ILD1. Although not illustrated, a passivation layer covering the first and second electrodes E1 and E2 may further be formed on the first interlayer insulating layer ILD1. In addition, after forming the passivation layer, annealing may be performed on the substrate SUB1 at a predetermined temperature in order to increase the properties of the TFT.

FIG. 6 is a graph illustrating gate voltage Vg - drain current Id characteristics versus a drain voltage Vd of the TFT of FIG. 3F. Referring to FIG. 6, it can be seen that the TFT has excellent switching characteristics even though when a drain voltage Vd of about 0.1V, which is low, is used.

Likewise, the TFT has a self-align top gate structure where locations of a source and drain regions are automatically determined according to a location of a gate electrode, and in which source and drain regions do not overlap a gate electrode. Also, because started from the same semiconductor oxide layer, the source region, the channel region, and the drain region are coplanar and do not overlap with each other. Since the TFT has an oxide semiconductor layer as a channel layer, de-hydrogen and crystallization are not required for forming the channel layer. In addition, since the source region and the drain region can be formed by only plasma-treating, instead of impurity-doping and activation, a manufacturing process can be simplified and manufacturing costs can be reduced.

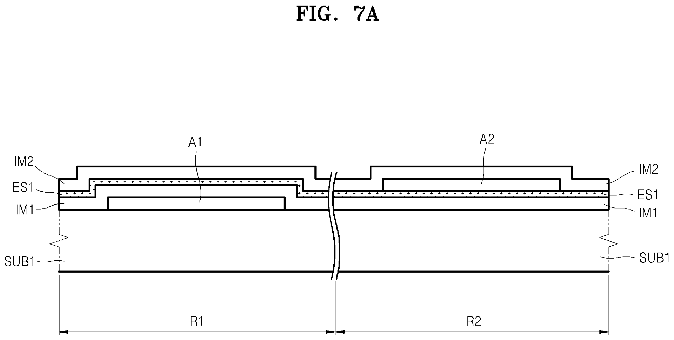

FIGS. 7A through 7H are cross-sectional views for explaining a method of manufacturing a semiconductor device including the TFT of FIG. 3F. The semiconductor device may be a complementary semiconductor device.

Referring to FIG. 7A, a substrate SUB1 including first and second regions R1 and R2 is prepared. One of the first and second regions R1 and R2 may be a region for forming an n-channel transistor, and the other one of first and second regions R1 and R2 may be a p-channel transistor. A first active layer A1 may be formed on the first region R1 of the substrate SUB1. The first active layer A1 may be the same as the first active layer A1 illustrated in FIGS. 1 and 2. The first active layer A1 may be one of an n-type oxide semiconductor layer and a p-type oxide semiconductor layer, for example, an n-type oxide semiconductor layer.

Next, a first insulating material layer IM1 covering the first active layer A1 is formed on an entire surface of the substrate SUB1. Prior to or after forming the first insulating material layer IM1, the first active layer A1 may be plasma-treated. Alternatively, the first insulating material layer IM1 may be formed using two operations, and the first active layer A1 may be plasma-treated between the two operations. The above plasma-treating may be the same as that described with reference to FIGS. 3A, 4A, and 4B.

An etch-stop layer ES1 is formed on an entire surface of the first insulating material layer IM1. A second active layer A2 is formed on the etch-stop layer ES1 of the second region R2. The second active layer A2 may be of an opposite type to the first active layer A1, for example, a p-type oxide semiconductor layer. A second insulating material layer IM2 covering the second active layer A2 is formed on the etch-stop layer ES1 of the first and second regions R1 and R2. Prior to or after forming the second insulating material layer IM2, the second active layer A2 may be plasma-treated. Alternatively, the second insulating material layer IM2 may be formed using two operations, and the second active layer A2 may be plasma-treated between the two operations. The above plasma processing may be the same as the plasma processing with respect to the first active layer A1, which has been described with reference to FIGS. 3A, 4A and 4B. The first insulating material layer IM1 and the second insulating material layer IM2 may be formed of the same material, for example, silicon oxide, and the etch-stop layer ES1 may be formed of a material (e.g., silicon nitride) having large etch selectivity with respect to the first insulating material layer IM1 and the second insulating material layer IM2.

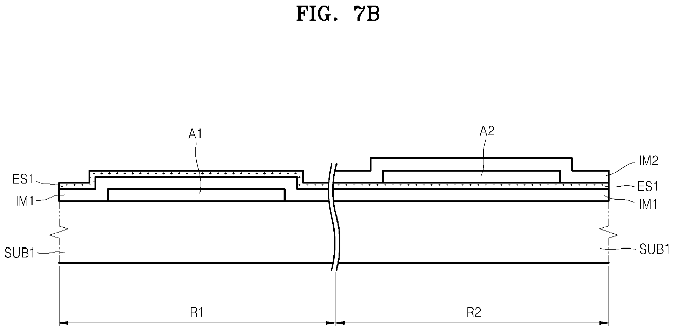

By etching the second insulating material layer IM2 of the first region R1, the etch-stop layer ES1 is exposed, as illustrated in FIG. 7B.

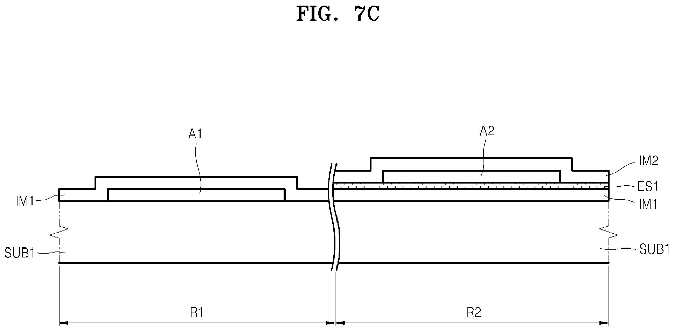

Next, by etching the etch-stop layer ES1 of the first region R1, the first insulating material layer IM1 is exposed, as illustrated in FIG. 7C. At this time, by using an etching gas or an etching solution, which selectively etches the etch-stop layer ES1, damage in the first insulating material layer IM1 can be prevented or minimized. However, if the first insulating material layer IM1 and the second insulating material layer IM2 are formed of different materials and etch selectivity therebetween is large, the etch-stop layer ES1 may not be formed. Thus, the etch-stop layer ES1 may be optionally formed.

Although not illustrated, in FIGS. 7B and 7C, during etching the second insulating material layer IM2 and the etch-stop layer ES1 of the first region R1, the second region R2 may be covered by a mask layer.

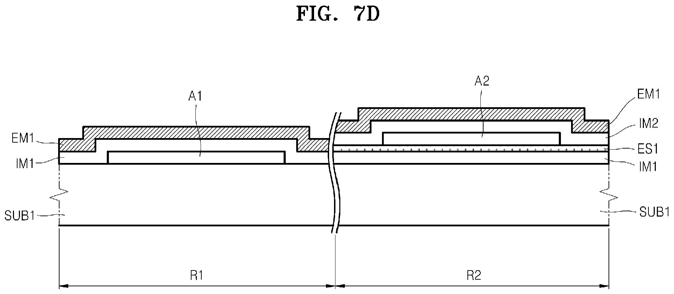

Referring to FIG. 7D, a first electrode material layer EM1 is formed on the first insulating material layer IM1 of the first region R1 and the second insulating material layer IM2 of the second region R2.

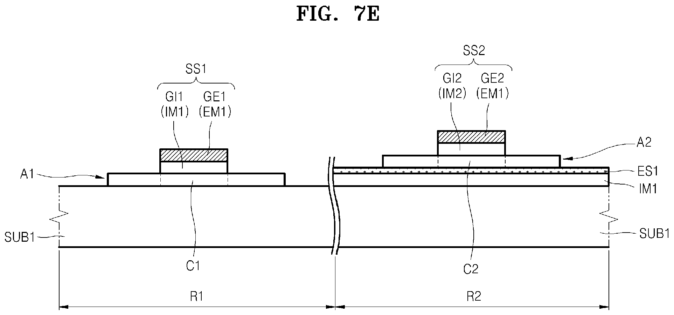

Next, the first electrode material layer EM1, the first insulating material layer IM1 and the second insulating material layer IM2 are patterned, and the resultant product is illustrated in FIG. 7E. Hereinafter, a patterned first insulating material layer IM1 and a patterned second insulating material layer IM2 are referred to as a first gate insulating layer GI1 and a second gate insulating layer G12, respectively. A left first electrode material layer EM1 of the first region R1 and a left first electrode material layer EM1 of the second region R2 are referred to as a first gate electrode GE1 and a second gate electrode GE2, respectively. The first gate insulating layer GI1 and the first gate electrode GE1 may be formed on a first channel region C1 of the first active layer A1 so as to constitute the first stack structure SS1. The second gate insulating layer GI2 and the second electrode GE2 may be formed on a second channel region C2 of the second active layer A2 so as to constitute the second stack structure SS2.

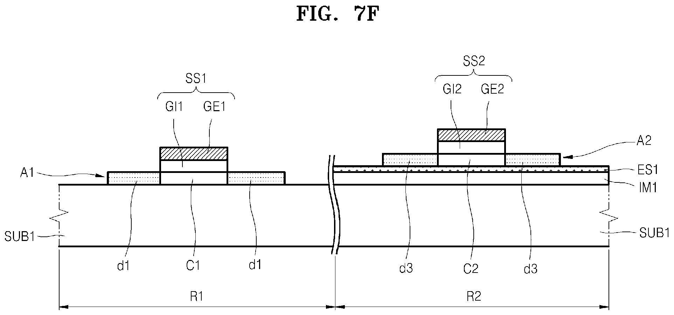

Referring to FIG. 7F, first plasma-treating is performed to portions of the first active layer A1, which are disposed on both sides of the first stack structure SS1, and portions of the second active layer A2, which are disposed on both sides of the second stack structure SS2, so as to form first conductive regions d1 in the portions of the first active layer A1, which are disposed on the both sides of the first stack structure SS1 and to form third conductive regions d3 in the portions of second active layer A2, which are disposed on the both sides of the second stack structure SS2. The first and third conductive regions d1 and d3 may have similar conductivity to that of a general LDD region. The first plasma-treating may be the same as that described with reference to FIG. 3D.

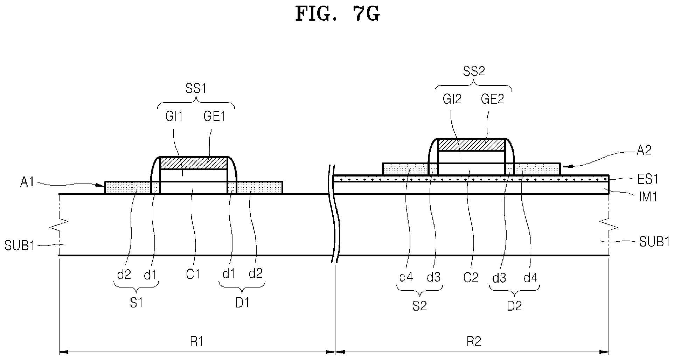

Referring to FIG. 7G, the first insulating spacers SP1 are formed on both side walls of the first stack structure SS1. The second insulating spacers SP2 are formed on both side walls of the second stack structure SS2.

Next, second plasma-treating is performed with respect to the first conductive regions d1 of both sides of the first insulating spacer SP1 and the first stack structure SS1, and the second conductive regions d2 of both sides of the second insulating spacer SP2 and the second stack structure SS2. As a result, second conductive regions d2 and fourth conductive regions d4 may be formed. The first and second conductive regions d1 and d2 of one side of the first stack structure SS1 may be a first source region S1, and the first and second conductive regions d1 and d2 of the other side of the first stack structure SS1 may be the first drain region D1. The third and fourth conductive regions d3 and d4 of one side of the second stack structure SS2 may be a second source region S2, and the third and fourth conductive regions d3 and d4 of the other side of the second stack structure SS2 may be a second drain region D2. The second plasma-treating may be the same as that described with reference to FIG. 3E.

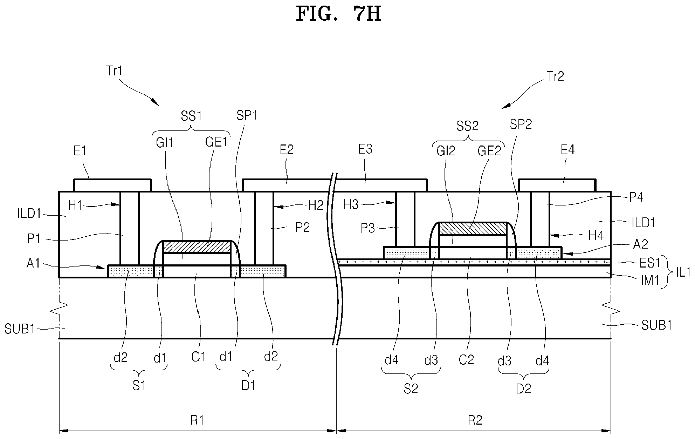

Referring to FIG. 7H, a first interlayer insulating layer ILD1 covering the first stack structure SS1, the first insulating spacer SP1, the first source region S1 and the first drain region D1 of the first region R1, and the second stack structure SS2, the second insulating spacer SP2, the second source region S2 and the second drain region D2 of the second region R2 may be formed. By etching the first interlayer insulating layer ILD1, first and second contact holes H1 and H2 respectively exposing the first source region S1 and the first drain region D1 are formed, and third and fourth contact hoes H3 and H4 respectively exposing the second source region S2 and the second drain region D2 are formed. Then, first through fourth conductive plugs P1 through P4 are formed in the first through fourth contact holes H1 through H4, respectively. First through fourth electrodes E1 through E4, which are respectively in contact with the first through fourth conductive plugs P1 through P4, are formed on the first interlayer insulating layer ILD1. Although not illustrated, a passivation layer covering the first through fourth electrodes E1 through E4 may further be formed on the first interlayer insulating layer ILD1. In addition, after the forming of the passivation layer, annealing may be performed on the substrate SUB1 at a predetermined temperature in order to increase the properties of the TFTs.

In the above devices, a source region and a drain region are formed by plasma-treating. However, the source region and the drain region may be formed by doping a material with conductive impurities and then activating the material in order to activate the doped impurities, instead of the plasma-treating. That is, in FIG. 3E, first type conductive impurities are injected into both ends of the first active layer A1, and annealing (i.e., the activating operation) is performed, instead of the second plasma-treating, thereby completing the formation of the first source region S1 and the first drain region D1. In addition, in FIG. 7G, the first type conductive impurities are injected into the first conductive region d1 on both sides of the first stack structure SS1 and first insulating spacer SP1, second type conductive impurities are injected into the third conductive region d3 on both sides of the second stack structure SS2 and second insulating spacer SP2, and annealing (i.e., activation) is performed, thereby completing the formation of the first and second source regions S1 and S2 and the first and second drain regions D1 and D2. In addition, the plasma-treating, the doping with impurities and the activating operation may be used together.

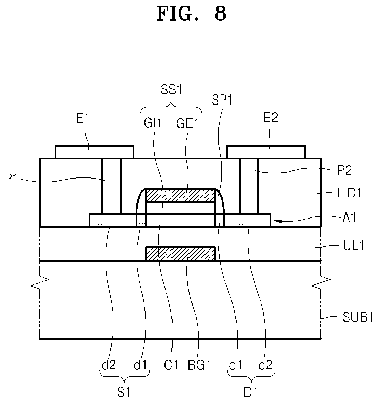

The TFTs illustrated in FIGS. 1 through 7H have single gate structures, but they may have a double gate structure. The TFT of FIG. 8 has a structure in which a first bottom gate electrode BG1 and a lower insulating layer UL1 are added to the TFT of FIG. 1.

Referring to FIG. 8, the first bottom gate electrode BG1 and the lower insulating layer UL1 covering the first bottom gate electrode BG1 may be disposed on a substrate SUB1. The lower insulating layer UL1 may be a silicon oxide layer or a silicon nitride layer, and may be another insulating material layer. The TFT of FIG. 1 may be disposed on the lower insulating layer UL1. In this case, the first channel region C1 may be disposed above the first bottom gate electrode BG1. Thus, the first channel region C1 can be controlled by the first bottom gate electrode BG1 disposed under the first channel region C1 and the first gate electrode GE1 disposed above the first channel region C1. The first bottom gate electrode BG1 may be separated from or electrically connected to the first gate electrode GE1. When the first bottom gate electrode BG1 is connected to the first gate electrode GE1, the first bottom gate electrode BG1 and the first gate electrode GE1 may be connected to each other by a conductive plug. Since the TFT of FIG. 8 has a double gate structure, a threshold voltage can be easily controlled. More particularly, when a predetermined negative (-) voltage is applied to any one of the first bottom gate electrode BG1 and the first gate electrode GE1, for example, the first bottom gate electrode BG1, the number of electrons of the first channel region C1 may be reduced. That is, a depletion region may be formed in the first channel region C1. Thus, it can be difficult to form an n-channel in the first channel region C1. This denotes that a threshold voltage increases. In other words, when a predetermined negative (-) voltage is applied to the first bottom gate electrode BG1, only if a greater voltage is applied to the first gate electrode GE1 compared to in the case where the predetermined negative (-) voltage is not applied to the first bottom gate electrode BG1, an n-channel can be formed in the first channel region C1. Thus, the TFT of FIG. 8 may be an enhancement mode transistor having a greater threshold voltage than 0 V. When a predetermined positive (+) voltage is applied to any one of the first bottom gate electrode BG1 and the first gate electrode GE1, since the number of electrons of the first channel region C1 increases, a threshold may be reduced. In this case, the TFT of FIG. 8 may be depletion mode transistor having a threshold voltage smaller than 0. Likewise, by applying a negative (-) or positive (+) voltage to any one of double gates, a threshold voltage can be easily controlled. In this case, when a voltage for controlling a threshold voltage is applied to any one of double gates, a normal operation voltage may be applied to the other one of the double gates.

In addition, when a predetermined positive (+) voltage is simultaneously applied to the first bottom gate electrode BG1 and the first gate electrode GE1, a threshold voltage of a transistor can be changed, for example, increased by the predetermined positive (+) voltage. With regard to this mechanism, electrons can be trapped in the lower insulating layer UL1 (i.e., a gate insulating layer) between the first bottom gate electrode BG1 and the first channel region C1 by the predetermined positive (+) voltage applied to the first bottom gate electrode BG1. Likewise, electrons can be trapped in the first gate insulating layer GI1 by the predetermined positive (+) voltage applied to the first gate electrode GE1, and it can be difficult to form an n-channel in the first channel region C1 by the trapped electrons. However, a threshold voltage can be increased by other factors. When a threshold voltage of a transistor is increased by applying a positive (+) voltage to the first bottom gate electrode BG1 and the first gate electrode GE1, since the increased threshold voltage can be maintained, a TFT can be operated by increasing a threshold voltage and then applying a normal operation voltage to at least one of the first bottom gate electrode BG1 and the first gate electrode GE1. A threshold voltage of an oxide TFT can be easily controlled, and an enhancement mode transistor or a depletion mode transistor can be easily embodied.

The TFT of FIG. 8 may be manufactured by forming the first bottom gate electrode BG1 on the substrate SUB1, forming the lower insulating layer UL1 covering the first bottom gate electrode BG1 and then forming the TFT of FIG. 1 on the lower insulating layer UL1. A method of the TFT of FIG. 1 may be the same as the method illustrated in FIGS. 3A through 3F or FIGS. 4A through 4b.

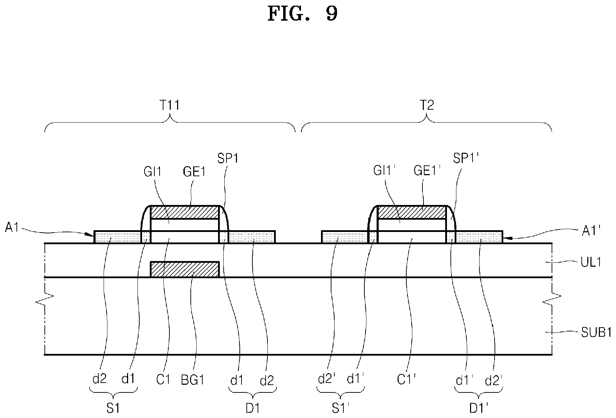

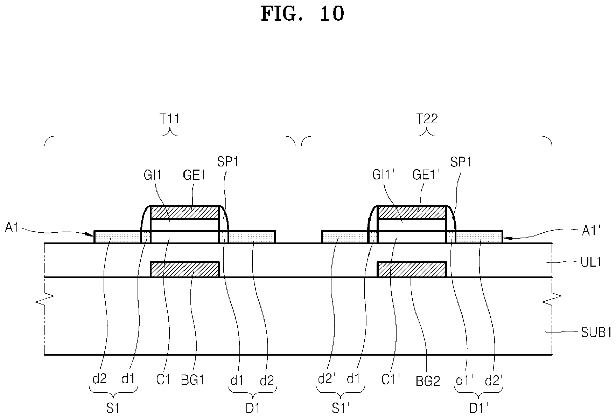

FIGS. 9 and 10 are cross-sectional views of a semiconductor device. Each of the semiconductor devices of FIGS. 9 and 10 includes the TFT of FIG. 8. For convenience of description, the first interlayer insulating layer ILD1, the first and second conductive plugs P1 and P2, the first and second electrodes E1 and E2, etc. of FIG. 8 are not illustrated in FIGS. 9 and 10.

Referring to FIG. 9, two TFTs (hereinafter, referred to as first and second TFTs) T11 and T2 are disposed on the substrate SUB1. The first TFT T11 may have a double gate structure that is the same as the TFT of FIG. 8. The TFT of FIG. 8 has a structure in which the first bottom gate electrode BG1 is added to the TFT of FIG. 1. The second TFT T2 may be formed on the lower insulating layer UL1, and may be a single gate structure. The second TFT T2 may be formed of the same material and may be formed in the same structure as the TFT of FIG. 1. In other words, in the structure of FIG. 9, two TFTs, each of which is the TFT of FIG. 1, may be disposed, and one (i.e., the first transistor T11) of the two TFTs T11 may be further include a first bottom gate electrode BG1. An active layer A1', a channel region C1', a conducive region d1', another conductive region d2', a source region S1', a drain region D1', a gate insulating layer GI1', a gate electrode GE1' and an insulating spacer SP1' of the second TFT T2 may correspond to the first active layer A1, the first channel region C1, the first conductive region d1, the second conductive region d2, the first source region S1, the first drain region D1, the first gate insulating layer GI1, the first gate electrode GE1 and the first insulating spacer SP1 of the first TFT T11, respectively. Thus, the first active layer A1 of the first TFT T11 and the active layer A1' of the second TFT T2 may be the same type (n or p) formed of the same material. The first active layer A1 and the active layer A1' may be formed on the same layer, that is the lower insulating layer UL1. Thus, the portion of the first TFT T11 on the lower insulating layer UL1 and the second TFT T2 may be formed by using the same process. In addition, the first drain region D1 of the first TFT T11 and the source region S1' of the second TFT T2 may be formed in contact with each other.

The modes of the first and second TFTs T11 and T2 may be the same or different. For example, one of the first and second TFTs T11 and T2 may be an enhancement mode, and the other one of the first and second TFTs T11 and T2 may be a depletion mode. If necessary, both the first and second TFTs T11 and T2 may each have an enhancement mode or a depletion mode.

In addition, the first and second TFTs T11 and T2 are electrically connected to constitute an inverter. In this case, one of the first and second TFTs T11 and T2 may be used as a load transistor of the inverter, and the other one of the first and second TFTs T11 and T2 may be used as a switching transistor of the inverter. Thus, inverters of various modes such as an enhancement/depletion (E/D) mode, an enhancement/enhancement (E/E) mode, etc. can be embodied. A circular configuration of an inverter including two transistors that are electrically connected is well known, and thus its detailed description is not given here. In addition, the inverter may be used as elementary devices of logic circuits such as an NAND circuit, an NOR circuit, an encoder, a decoder, a multiplexer (MUX), a de multiplexer (DEMUX) and a sense amplifier. The basic configuration of the logic circuits is well known, and thus its detailed description is not given here. As the first and second TFTs T11 and T2 may constitute an inverter, the first type TFT Tr1 and the second type TFT Tr2 may also constitute an inverter. This can be applied to the semiconductor devices of FIGS. 10, 12 and 13.

The second TFT T2 of FIG. 9 may have a double gate structure. Such an example is illustrated in FIG. 10.

Referring to FIG. 10, a second bottom gate electrode BG2 is disposed under the channel region C1' of the second transistor T22. Thus, both first and second TFTs T11 and T22 each have a double gate structure. A semiconductor device of FIG. 10 may be the same as FIG. 9 except that the second bottom gate electrode BG2 is added. Due to such as double gate structure, a threshold voltage of the first and second TFTs T11 and T22 can be easily controlled. Modes of the first and second TFTs T11 and T22 may be the same or different. The semiconductor device of FIG. 10 may be used to constitute an inverter, a logic circuit including an inverter, and other various devices.

The semiconductor device of FIG. 10 may be manufactured by forming first and second bottom gate electrodes BG1 and BG2 on the substrate SUB1, forming a lower insulating layer UL1 covering the first and second bottom gate electrodes BG1 and BG2 and then forming two top gate TFTs (each of which is TFT of FIG. 1) corresponding to the first and second bottom gate electrodes BG1 and BG2 on the lower insulating layer UL1. A method of manufacturing the top gate TFT (TFT of FIG. 1) may be the same as the method described with reference to FIGS. 3A through 3F or FIGS. 4A and 4B.

According to the above examples, a TFT includes a single layer type active layer (channel region). However, a TFT may have a multilayer type active layer (channel region), which will be described.

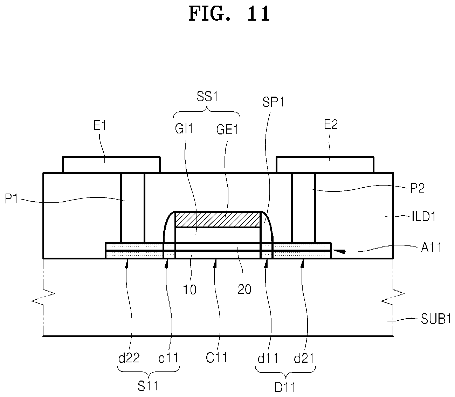

FIG. 11 is a cross-sectional view of a TFT, according to an embodiment of the present invention.

Referring to FIG. 11, a first active layer A11 includes a multilayer structure including at least two layers that are different from each other. For example, the first active layer A11 has a double-layer structure including a first layer 10 and a second layer 20 disposed on the first layer 10. The first and second layers 10 and 20 of a first source region S11 and a first drain region D11 may be a region that is plasma-treated so as to have high electrical conductivity. That is, the first and second layers 10 and 20 of the first source region S11 and the first drain region D11 may be a region that is plasma-treated using the same method as in the first source region S1 and the first drain region D1 of FIG. 1. Thus, the first and second layers 10 and 20 of the first source region S11 and the first drain region D11 and the first and second layers 10 and 20 of the first channel region C11 have different properties. The first and second layers 10 and 20, which will be described later, denote the first and second layers 10 and 20 of the first channel region C11. The first layer 10 and the second layer 20 have different mobility. The second layer 20 is more adjacent to the first gate electrode GE1 compared to the first layer 10, and may increase the mobility of the TFT That is, when the second layer 20 is provided, the mobility of the TFT can be increased compared to the case where the second layer 20 is not provided (that is, the case where the first channel C11 is formed of only a material of the first layer 10). The first layer 10 is further than the second layer 20 from the first gate electrode GE1. A threshold voltage of the TFT is more controlled by the first layer 10 than by the second layer 20. For example, when the thickness of the second layer 20 is fixed to an appropriate level, a threshold voltage of the TFT can be controlled according to the material, composition, carrier concentration, etc. of the first layer 10. When the first layer 10 is provided, a threshold voltage of the TFT may be moved in a positive (+) direction compared to the case where the first layer 10 is not provided (that is, the case where the first channel region C11 is formed of only a material of the second layer 20). Thus, the TFT may be an enhancement TFT having high mobility and a positive (+) threshold voltage. To achieve this, the first layer 10 inludes GalnZnO. The first layer 10 may be doped with a group 4 element such as Sn or other elements. The second layer 20 includes at least one of indium zinc oxide (IZO), indium tin oxide (ITO), aluminum zinc oxide (AZO), gallium zinc oxide (GZO) and mixtures including at least one of the foregoing, or may include an having greater electrical conductivity than that of the first layer 10. The thickness of the second layer 20 may be about 10 to about 200 Å, and more particularly, about 30 to 100 Å. When the second layer 20 is too thin, an effect of increasing the mobility of the TFT due to the second layer 20 can be reduced. When the second layer 20 is too thick, since it is difficult to form a channel in the first layer 10, a function of controlling a threshold voltage of the first layer 10 can deteriorate. That is, when the second layer 20 is too thick, a threshold voltage of the TFT can be determined by the second layer 20 rather than by the first layer 10. Thus, the second layer 20 may be formed to a thickness of about 10 to 200 Å. Alternatively, the second layer 20 may be formed to a thickness of about 30 to 100 Å in terms of a function of controlling a threshold voltage. However, the thickness may vary according to the size and kind of a TFT The first layer 10 may be formed to a thickness of about 10 to 2000 Å, wherein the thickness may be the same as or greater than that of the second layer 20. The TFT according to the present embodiment may not limited to an enhancement TFT That is, if necessary, the TFT may be a depletion mode TFT.

A plasma processing with respect to the first active layer A11 having a double-layer structure may be the same as the plasma processing which has been described with reference to FIGS. 3A, 3D, 3E and 4A. The first source region S11 and the first drain region D11 are formed by the plasma processing, and the first channel region C11 may be defined between the first source region S11 and the first drain region D11. Even if the second layer 20 includes one of IZO, ITO, AZO, GZO and a mixture including at least one of the foregoing, or other oxide, the effect generated by the plasma processing may be the same as the plasma processing in FIGS. 3A, 3D, 3E and 4A. The structure of FIG. 11 except for the first active layer A11 may be the same as that of FIG. 1, and a manufacturing method thereof may be the same as the case of FIG. 1.

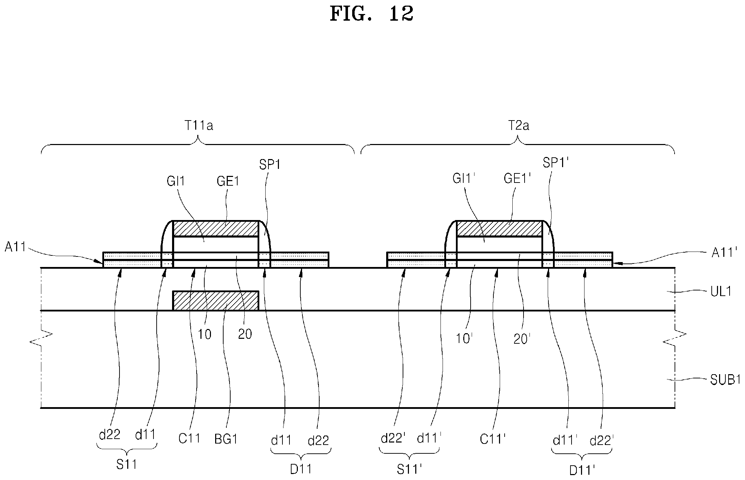

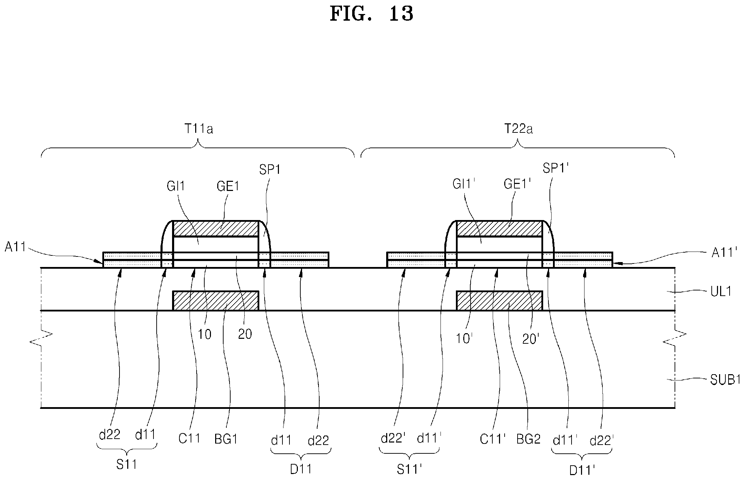

Two TFTs which each have the same structure of FIG. 11 may be disposed on the substrate SUB1, and a bottom gate electrode may be disposed below at least one of the two TFTs, an example of which is illustrated in FIGS. 12 and 13. For convenience of description, in FIGS. 12 and 13, the first interlayer insulating layer ILD1, the first and second conductive plugs P1 and P2, and the first and second electrodes E1 and E2 , etc. of FIG. 11 are not illustrated .

Referring to FIG. 12, the first bottom gate electrode BG1 and the lower insulating layer UL1 covering the first bottom gate electrode BG1 may be disposed on the substrate SUB1. Atop gate transistor having the same structure as the TFT of FIG. 11 may be disposed on a portion of the lower insulating layer UL1, which corresponds to the first bottom gate electrode BG1. The top gate transistor and the first bottom gate electrode BG1 may constitute a first TFT T11a having a double gate structure. Another top gate transistor, that is, a second TFT T2a having the same structure as the TFT of FIG. 11 may be disposed on another portion of the lower insulating layer UL1. An active layer A11', a channel region C11', a conductive region d11', another conductive region d22', a source region S11', a drain region D11', a gate insulating layer GI1' a gate electrode GE1' and an insulating spacer SP1' in the second TFT T2a may correspond to a first active layer A11, a first channel region C11, a conductive region d11, another conductive region d22, a first source region S11, a first drain region D11, a first gate insulating layer G11, a first gate electrode GE1 and a first insulating spacer SP1 in the first TFT T11 a, respectively. The structure of FIG. 12 except for the active layers A11 and A11' may be the same as the structure of FIG. 9. Modes of the first and second TFTs T11a and T2a may be different or the same.

The second TFT T2a of FIG. 12 may also have a double gate structure, an example of which is illustrated in FIG. 13.

Referring to FIG. 13, the second bottom gate BG2 is disposed below the channel region C11' of the second TFT T22a. Thus, both of the first and second TFTs T11 a and T22a may each have a double gate structure. The structure of FIG. 13 except for the second bottom gate BG2 may be the same as the structure of FIG. 12.

It should be understood that the exemplary embodiments described therein should be considered in a descriptive sense only and not for purposes of limitation. Descriptions of features or aspects within each embodiment should typically be considered as available for other similar features or aspects in other embodiments. It will be obvious to those of ordinary skill in this art that, for example, the constituent elements of TFT and semiconductor device including the TFT can be varied and the structure of the TFT and semiconductor device including the TFT can also be modified. In addition, the TFT can be applied to fields of a memory device and logic device as well as a liquid crystal display device (LCD) and an organic light emitting display device (OLED). Therefore, the scope of the invention is defined not by the detailed description of the invention but by the appended claims.

## Claims

1. A semiconductor device comprising a first thin film transistor (TFT) including:
a first oxide semiconductor layer (A11) formed on a substrate (SUB1) and having a first source region (S11), a first drain region (D11), and a first channel region (C11) between the first source region and the first drain region; and
a first stack structure (SS1) including a first gate insulating layer (GI1) and a first gate electrode (GE1) which are sequentially stacked on the first channel region,
**characterised in that** the first oxide semiconductor layer (A11) comprises a double-layer structure in which a first layer (10) and a second layer (20) are sequentially stacked,
wherein a thickness of the first layer and a thickness of the second layer are such that a threshold voltage of the TFT is determined by the first layer and the mobility of the TFT is determined by the second layer; and
the first layer includes GalnZnO, and the second layer includes at least one of IZO, ITO, AZO, GZO and a mixture thereof, wherein the second layer is of a different material to the first layer.

2. The semiconductor device of claim 1, wherein the first source and drain regions (S11,D11) have a higher conductivity than the first channel region (C11).

3. The semiconductor device of claim 1 or 2, wherein at least one of the first source and drain regions (S11,D11) has a plasma-treated low resistive region.

4. The semiconductor device of any preceding claim, wherein each of the first source region (S11) and the first drain region (D11) comprises two regions having different conductivities, wherein a region of the two regions, having smaller conductivity than the other region, is adjacent to the first channel region.

5. The semiconductor device of claim 4, further comprising first insulating spacers (SP1) on both side walls of the first stack structure, wherein the region of the two regions, having smaller than conductivity than the other region, is disposed below each of the first insulating spacers.

6. The semiconductor device of any preceding claim, further comprising a second TFT (T2a),
wherein the second TFT comprises:
a second oxide semiconductor layer (A11') having a second source region (S11'), a second drain region (D11'), and a second channel region (C11') between the second source region (S11') and the second drain region (D11'); and
a second stack structure comprising a second gate insulating layer (GI1') and a second gate electrode (GE1'), which are sequentially stacked on the second channel region (C11').

7. The semiconductor device of claim 6, wherein the second oxide semiconductor layer (A11') has a different type from the first oxide semiconductor layer (A11), an insulating layer (IM1) is further disposed between the substrate and the second TFT, and the first and second oxide semiconductor layers (A11,A11') are disposed on different layers.

8. The semiconductor device of claim 7, wherein an etch stop layer (ES1) is further disposed between the insulating layer (IM1) and the second TFT, and
wherein the first gate insulating layer (GI1) is formed of the same material as the insulating layer (IM1).

9. The semiconductor device of claim 6, wherein the first and second oxide semiconductor layers (A11,A11') are the same type, and the first and second oxide semiconductor layers are formed on the same layer (UL1).

10. The semiconductor device of any of claims 6 to 9, further comprising a bottom gate electrode (BG1) disposed below at least one of the first channel region (C11) and the second channel region (C11').

11. The semiconductor device of any of claims 6 to 10, wherein the second oxide semiconductor layer (A11') comprises a double-layer structure in which a first layer (10') and a second layer (20') are sequentially stacked, the first layer (10') includes GalnZnO, and the second layer (20') includes at least one of IZO, ITO, AZO, GZO and a mixture thereof, wherein the first layer (10") and the second layer (20") are of different materials.

12. The semiconductor device of any of claims 6 to 11, wherein at least one of the second source and drain regions (S11',D11') has a plasma-treated low resistive region.

## Patentansprüche

1. Halbleiterbauelement, das einen ersten Dünnschichttransistor (TFT) umfasst, beinhaltend:
eine erste Oxid-Halbleiterschicht (A11), die auf einem Substrat (SUB1) ausgebildet ist und eine erste Source-Region (S11), eine erste Drain-Region (D11) und eine erste Kanalregion (C11) zwischen der ersten Source-Region und der ersten Drain-Region aufweist; und
eine erste Stapelstruktur (SS1), die eine erste Gate-Isolierschicht (GI1) und eine erste Gate-Elektrode (GE1) beinhaltet, die sequenziell auf der ersten Kanalregion gestapelt sind,
**dadurch gekennzeichnet, dass** die erste Oxid-Halbleiterschicht (A11) eine Doppelschichtstruktur umfasst, in der eine erste Schicht (10) und eine zweite Schicht (20) sequenziell gestapelt sind,
wobei eine Dicke der ersten Schicht und eine Dicke der zweiten Schicht derart sind, dass eine Schwellenspannung des TFT durch die erste Schicht bestimmt wird und die Mobilität des TFT durch die zweite Schicht bestimmt wird; und
die erste Schicht GalnZnO beinhaltet und die zweite Schicht mindestens eines von IZO, ITO, AZO, GZO und einem Gemisch davon beinhaltet, wobei die zweite Schicht aus einem anderen Material als die erste Schicht ist.

2. Halbleiterbauelement nach Anspruch 1, wobei die erste Source-Region und die erste Drain-Region (S11, D11) eine höhere Leitfähigkeit als die erste Kanalregion (C11) aufweisen.

3. Halbleiterbauelement nach Anspruch 1 oder 2, wobei mindestens eine der ersten Source-Region und der ersten Drain-Region (S11, D11) eine plasmabehandelte Region mit niedrigem Widerstand aufweist.

4. Halbleiterbauelement nach einem vorhergehenden Anspruch, wobei jede der ersten Source-Region (S11) und der ersten Drain-Region (D11) zwei Regionen mit unterschiedlichen Leitfähigkeiten umfasst, wobei eine Region der zwei Regionen mit einer geringeren Leitfähigkeit als die andere Region an die erste Kanalregion angrenzt.

5. Halbleiterbauelement nach Anspruch 4, das weiterhin erste Isolierabstandshalter (SP1) auf beiden Seitenwänden der ersten Stapelstruktur umfasst, wobei die Region der zwei Regionen mit einer geringeren Leitfähigkeit als die andere Region unter jedem der ersten Isolierabstandshalter angeordnet ist.

6. Halbleiterbauelement nach einem vorhergehenden Anspruch, das weiterhin einen zweiten TFT (T2a) umfasst,
wobei das zweite TFT Folgendes umfasst:
eine zweite Oxid-Halbleiterschicht (All'), die eine zweite Source-Region (S11'), eine zweite Drain-Region (D11') und eine zweite Kanalregion (C11') zwischen der zweiten Source-Region (S11') und der zweiten Drain-Region (D11') aufweist; und
eine zweite Stapelstruktur, die eine zweite Gate-Isolierschicht (GI1') und eine zweite Gate-Elektrode (GE1') umfasst, die sequenziell auf der zweiten Kanalregion (C11') gestapelt sind.

7. Halbleiterbauelement nach Anspruch 6, wobei die zweite Oxid-Halbleiterschicht (A11') einen anderen Typ als die erste Oxid-Halbleiterschicht (A11) aufweist, eine Isolierschicht (IM1) weiterhin zwischen dem Substrat und dem zweiten TFT angeordnet ist und die erste und die zweite Oxid-Halbleiterschicht (A11, A11') auf unterschiedlichen Schichten angeordnet sind.

8. Halbleiterbauelement nach Anspruch 7, wobei eine Ätzstoppschicht (ES1) weiterhin zwischen der Isolierschicht (IM1) und dem zweiten TFT angeordnet ist und
wobei die erste Gate-Isolierschicht (GI1) aus demselben Material wie die Isolierschicht (IM1) ausgebildet ist.

9. Halbleiterbauelement nach Anspruch 6, wobei die erste und die zweite Oxid-Halbleiterschicht (A11, A11') von demselben Typ sind und die erste und die zweite Oxid-Halbleiterschicht aus derselben Schicht (UL1) ausgebildet sind.

10. Halbleiterbauelement nach einem der Ansprüche 6 bis 9, das weiterhin eine untere Gate-Elektrode (BG1) umfasst, die unter mindestens einer der ersten Kanalregion (C11) und der zweiten Kanalregion (C11') angeordnet ist.

11. Halbleiterbauelement nach einem der Ansprüche 6 bis 10, wobei die zweite Oxid-Halbleiterschicht (A11') eine Doppelschichtstruktur umfasst, in der eine erste Schicht (10') und eine zweite Schicht (20') sequenziell gestapelt sind, wobei die erste Schicht (10') GaInZnO beinhaltet und die zweite Schicht (20') mindestens eines von IZO, ITO, AZO, GZO und einem Gemisch davon beinhaltet, wobei die erste Schicht (10") und die zweite Schicht (20") aus unterschiedlichen Materialien sind.

12. Halbleiterbauelement nach einem der Ansprüche 6 bis 11, wobei mindestens eine der zweiten Source-Region und der zweiten Drain-Region (S11, D11') eine plasmabehandelte Region mit niedrigem Widerstand aufweist.

## Revendications

1. Dispositif à semi-conducteur comprenant un premier transistor à film mince (TFT), y compris :
une première couche d'oxyde semi-conducteur (A11) formée sur un substrat (SUB1) et possédant une première zone source (S11), une première zone drain (D11), et une première zone de canal (C11) entre la première zone source et la première zone drain ; et
une première structure empilée (SS1) comprenant une première couche d'isolation de grille (GI1) et une première électrode de grille (GE1) empilées en séquence sur la première zone de canal,
**caractérisé en ce que** la première couche d'oxyde semi-conducteur (A11) comprend une structure à double couche dans laquelle une première couche (10) et une seconde couche (20) sont empilées en séquence,
une épaisseur de la première couche et épaisseur de la deuxième couche étant telles qu'une tension seuil du TFT est déterminée par la première couche, et la mobilité du TFT est déterminée par la seconde couche ; et
la première couche contient du GalnZnO, et la seconde couche au moins un des suivants : IZO, ITO, AZO, GZO, et un mélange de ces derniers, la deuxième couche étant composée de matériaux différents de ceux de la première couche.

2. Dispositif à semi-conducteur selon la revendication 1, les premières zones source et drain (S11, D11) présentant une conductivité supérieure à celle de la première zone de canal (C11).

3. Dispositif à semi-conducteur selon la revendication 1 ou 2, au moins une des premières zones source et drain (S11, D11) possédant une zone à faible résistance traitée au plasma.

4. Dispositif à semi-conducteur selon une quelconque des revendications précédentes, chacune de la première zone source (S11) et de la première zone drain (D11) comprenant deux zones présentant différentes conductivités, une zone des deux zones, présentant une conductivité inférieure à celle de l'autre zone, étant adjacente à celle de la première zone de canal.

5. Dispositif à semi-conducteur selon la revendication 4, comprenant en outre des premières entretoises isolantes (SP1) sur les deux parois latérales de la première structure empilée, la zone des deux zones, dont la conductivité est inférieure à celle de l'autre zone, étant disposée sous chacune des premières entretoises isolantes.

6. Dispositif à semi-conducteur selon une quelconque des revendications précédentes, comprenant en outre un deuxième TFT (T2a),
le deuxième TFT comprenant :
une deuxième couche d'oxyde semi-conducteur (A11') présentant une deuxième zone source (S11'), une deuxième zone drain (D11'), et une deuxième zone de canal (C11') entre la deuxième zone source (S11') et la deuxième zone drain (D11') ; et
une deuxième structure empilée comprenant une deuxième couche d'isolation de grille (GI1') et une deuxième électrode de grille (GE1') empilée en séquence sur la deuxième zone de canal (C11').

7. Dispositif à semi-conducteur selon la revendication 6, la deuxième couche d'oxyde semi-conducteur (A11') étant d'un type différent de la première couche d'oxyde semi-conducteur (A11), une couche isolante (IM1) étant disposée en outre entre le substrat et le deuxième TFT, et les première et deuxième couches d'oxyde semi-conducteur (A11, A11') étant disposées sur différentes couches.

8. Dispositif à semi-conducteur selon la revendication 7, une couche d'arrêt de gravure (ES1) étant disposée en outre entre la couche isolante (IM1) et le deuxième TFT, et
la première couche d'isolation de grille (GI1) étant formée avec le même matériau que la couche isolante (IM1).

9. Dispositif à semi-conducteur selon la revendication 6, les première et deuxième couches d'oxyde semi-conducteur (A11, A11') étant du même type, et les première et deuxième couches d'oxyde semi-conducteur étant formées sur la même couche (UL1).

10. Dispositif à semi-conducteur selon une quelconque des revendications 6 à 9, comprenant en outre une électrode de grille inférieure (BG1) disposée sous au moins une de la première zone de canal (C11) et de la deuxième zone de canal (C11').

11. Dispositif à semi-conducteur selon une quelconque des revendications 6 à 10, la deuxième couche d'oxyde semi-conducteur (A11') comprenant une structure à double couche dans laquelle une première couche (10') et une deuxième couche (20') sont empilées en séquence, la première couche (10') comprenant du GalnZnO, et la seconde couche (20') comprenant au moins un des suivants : IZO, ITO, AZO, GZO, et un mélange de ces derniers, les première (10") et deuxième couches (20") étant composées de matériaux différents.

12. Dispositif à semi-conducteur selon une quelconque des revendications 6 à 11, au moins une des deuxième zones source et drain (S11', D11') possédant une zone à faible résistance traitée au plasma.
